# EUROPEAN PATENT APPLICATION

(11) **EP 0 869 704 A1**
(43) Date of publication of application: **07.10.1998**
(21) Application number: 97310707.1
(22) Date of filing: 31.12.1997
(51) Int. Cl.: H05K 3/34

(54) **Method of mounting components on a printed circuit board**

(30) Priority: 31.03.1997 US 829075
(71) Applicant: Ford Motor Company, Dearborn, MI 48126 (US)
(72) Inventor: Cardellino, Terri Ann, Newtown, PA 18940 (US); Ford, Douglas Montgomery, Lansdale, PA 19446 (US); Davis, Russell William, Berlin, N.J. 08009 (US)
(74) Representative: Messulam, Alec Moses

(57) **Abstract**

The present invention provides a method of making a printed circuit board assembly. The method includes the steps of applying a solder paste (62) to a substrate (42) and partially filling vias (44) in the substrate (42) and assembling electrical components (54) thereto. The method further includes heating the printed circuit board (40) to cause the solder paste (62) to reflow and then cooling the printed circuit board (44).

## Description

The present invention relates generally to electronics manufacturing. More particularly, the present invention relates to a method of making a printed circuit board assembly utilizing a solder paste having a polymer flux component thereto.

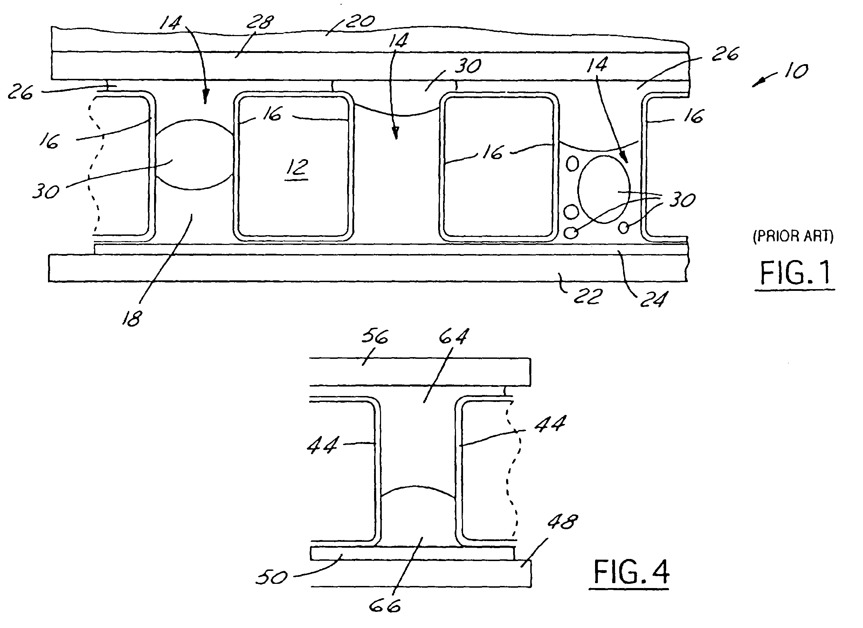

Figure 1 shows a cross-sectional, schematic view of a typical printed circuit board 10 manufactured according to known processes. The printed circuit board 10 includes a substrate 12 of known material having a plurality of vias 14. The vias generally are copper plated through holes 16 in the board substrate. These vias typically are plugged or filled by the board manufacturer with a thermally insulating, non-solderable epoxy material 18. The purpose of this material 18 is to isolate an electrical component 20 secured on one side of the board from a heat sink 22 on an opposite side of the board. A thermal adhesive layer 24 secures the heat sink 22 to the board 12. As shown in figure 1, the component includes its own heat sink 28.

As is also well known, a solder paste 26 is used to secure the electrical components to the board substrate 12. When all of the components are placed on the board 12, the solder paste is caused to reflow in a conventional manner. During this process, the wetting characteristics and dynamics of the solder paste cause the solder 26 printed on one side of the board to flow through the via. The printed circuit board is then cooled to harden the solder with the cured polymer. Alternatively, the activation/reflow of the solder paste and the curing of the polymer can occur at the same time in one process step.

In operation, the electrical component can produce excessive amounts of heat which initially are transferred to the component heat sink 28. This heat needs to be transferred away from the component heat sink. Ideally, this is accomplished through the copper plated vias 14 and solder 26 to the assembly heat sink 22, which carries the heat away from the printed circuit board. However, because the vias need to be filled by the board manufacturer with thermally insulating epoxy material 18, heat is only transferred through the copper plating in the vias. Furthermore, because the epoxy is non-solderable, it is non-wettable with the liquid solder such that voids 30 often form during the reflow process of the printed circuit board assembly, thus further interfering with heat transfer. Also, since the solder 26 cannot flow into the vias, it collects under the component, causing the component to become misaligned due to floating on the liquid solder. Furthermore, the thermal bonding side of the board may be contaminated, if the epoxy plug was not present, with a solder flux residue that provides poor adhesion and does not provide a uniform, planar surface for electrical isolation because high spots of solder will exist on that side of the board. Therefore, it would be advantageous to provide a method for manufacturing a printed circuit board assembly which eliminates these problems.

The present invention with known electronics provides a method of securing components to a printed circuit board having a plurality of vias therethrough, the method comprising the steps of applying a solder paste including a solder powder and a solder flux containing a polymer activator onto a surface of the printed circuit board in a predefined pattern and at least partially fill a plurality of thermal vias contained in the printed circuit board. The method further comprises assembling the components onto the printed circuit board such that the components are placed over the thermal vias and that electrical contacts of the components are in contact with predefined areas on the solder paste coated printed circuit board. The next step of the method is to heat the printed circuit board to a temperature and for a period of time sufficient to cause the solder paste to reflow, wetting the component and the printed circuit board pad and flowing solder into the vias to secure the component to the printed circuit board and form a thermal conduit for transferring heat from the electrical component to an assembly heat sink through the vias. This step also simultaneously cures the polymer flux/activator. The final step in the method is to allow the printed circuit board to cool. In the preferred embodiment of the present invention, approximately 25-80% of the volume of the thermal via is filled with the solder paste.

It is an advantage of the present invention that the amount of filling of the vias after reflow heating can be controlled for effective heat transfer. It is a further advantage that a void-free solder thickness for the component attach will result, thereby assuring consistent heat transfer from the component's heat sink to the thermal via.

It is also an advantage that the present invention will prevent components from becoming mis-aligned or floating during the reflow process.

The present invention also provides a non-contaminated thermal bonding side and consistent electrical isolation between the board and the assembly heat sink.

The invention will now be described further, by way of example, with reference to the accompanying drawings, in which:
Figure 1 is cross-sectional, schematic view of a printed circuit board manufactured according to prior art processes;
Figure 2 is a schematic view of a printed circuit board structured in accord with the principles of the present invention;
Figure 3 is an enlarged view of an electronic component, such as a surface mounted device, secured to a printed circuit board in accord with the principles of the present invention; and
Figure 4 is a cross-sectional, schematic view of a printed circuit board manufactured according to the method of the present invention.

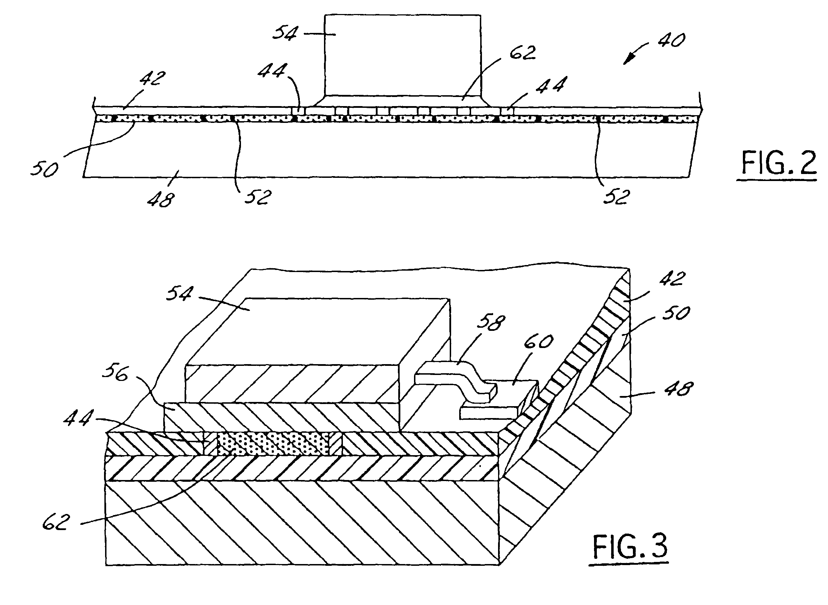

Referring now to the drawings, Figures 2 and 3 show a printed circuit (or wiring) board ("PCB" or "PWB") assembly 40 manufactured according to the present invention. The assembly 40 includes a generally planar substrate (PCB) 42 of known material having a plurality of vias 44 disposed therethrough. The vias 44 are generally barrel-shaped 46 and typically manufactured from copper or other high heat transferring material. The printed circuit board assembly 40 further includes a heat sink 48 secured to the PCB substrate 42 by a layer of thermal adhesive 50. The heat sink 48 can be fabricated from aluminum or other material having a high coefficient of heat transfer. The thermal adhesive layer 50 may include integral glass shim beads 52 as is well known in the art, to provide a consistent dielectric thickness.

The printed circuit board assembly 40 includes an electrical component 54, such as a surface mounted power device. The component 54 includes a heat dissipating layer or heat sink 56 and a plurality of leads or contacts 58. As is known in the circuit board art but not illustrated here, a circuit is formed on the top and/or bottom surfaces of the substrate. The leads 58 of the component 54 are attached to the circuit at pads 60 in a soldering process. The component 54 is also secured to the substrate 42 by the process of the present invention.

The method of the present invention to manufacture the printed circuit board assembly 40 will now be described. Generally, a substrate 42 having a plurality of vias 44 is provided. The first step in the method is to apply a solder paste 62 to the substrate. Generally, the solder paste 62 is screened or template printed onto the surface of the substrate, including the pads 60 to which the component leads 58 are secured. During this step, the vias 44 are partially filled with the solder paste 62. Preferably, the vias are filled between 25-80% of their volume depending upon a number of criteria, including via diameter, substrate depth, size of the component to be secured over the via and the composition of the solder paste. In the preferred embodiment of the invention, the solder paste must include a solder powder, a solder flux and a polymer flux/activator such as an epoxy resin for reasons which will be explained below. One commercially available solder paste which meets this requirement is AP-800, available from Alpha Metals Company in Jersey City, NJ. This solder paste is also described in U.S. Patent Number 5,088,189, the disclosure of which, beginning at column 5, line 1, through column 8, line 5, is hereby incorporated by reference. A second commercially available solder paste which meets this requirement is NC-559, available from Amtech, Inc., in Branford, Connecticut.

After the paste 62 has been applied, the electrical components 54 are assembled on the board 42. The electrical components 54 are positioned such that electrical leads 58 from the components contact the pads 60. The electrical components 54 can be placed on both the top and bottom surfaces of the board 42 with the power devices (heat generating devices) typically disposed directly over a plurality of vias 44. Next, the printed circuit board is subjected to a heating process to cause the solder paste to reflow. The heating is done at a predetermined temperature for a predetermined time depending upon the composition of the solder paste. One method suitable for heating the solder paste is by moving the printed circuit board through an infrared furnace. Generally the solder paste is heated to about 25 degrees C above the melting point of the solder alloy for approximately 30 to 100 seconds in order to cause the solder paste to reflow. The heating of the solder paste also starts the polymer activator and curing process.

The printed circuit board is then allowed to cool. The resulting printed circuit board assembly cross-section is shown in Figure 4. As shown in Figure 4, the solder connection 64 formed from the solder paste 62 has wetted along the bottom side of the component heat sink 56 and has flowed by capillary flow into the vias 44. A separate polymer flux residue portion 66 has been formed proximate the thermal adhesive layer 50. No voids have been formed to interfere with heat transfer through the vias 44. Because the solder in the preferred solder paste 62 is thermally conductive and now fills the via, unlike prior art compositions where the via was filled with thermally insulating, non-solderable polymers, heat can effectively and quickly transferred from component heat sink 56, through copper plated walls 46 of the vias and also through the solder 64 in the vias 44 to assembly heat sink 48.

Because the wetting and dynamic characteristics of the solder paste 62 are known, the amount of filling of each via can be controlled. Overfilling the vias upon application of the solder paste can cause floating of the components. Therefore, it is necessary that only 25-80% of the via be filled. This partial filling of the vias results because the cured polymer matrix in solder paste 62 migrates less than prior art rosin-based compositions. By controlling the filling of the vias, the amount of solder flux material on the thermal bonding side (the side where the substrate is secured to heat sink 48) can be minimized so as not to interfere with heat transfer. The non-migrating behavior of the polymer flux also controls the volume of solder in the thermal via and provides a larger cross-sectional area of metal for heat transfer from the component through the substrate. Also, the cured polymer has excellent adhesion to the board and compatibility with thermal bonding to the heat sink 48 unlike rosin-based fluxes.

## Claims

1. A method of securing components to a printed circuit board having a plurality of vias therethrough, comprising the steps of:
applying a solder paste (62) including a solder powder and a polymer flux onto a surface of the printed circuit board (40) in a predefined pattern and to at least partially fill a plurality of thermal vias (44) contained in the printed circuit board;
assembling the components (54) onto the printed circuit board such that the components are placed over the thermal vias (44) and that electrical contacts of the components are in contact with predefined areas on the solder paste (62) coated printed circuit board;
heating the printed circuit board (40) to a temperature and for a period of time sufficient to cause the solder paste (62) to reflow, wetting the components (54) and the predefined areas on the printed circuit board to secure the component (54) to the printed circuit board (40) and form a thermal conduit for transferring heat from the electrical component to a heat sink (48) through the vias (44); and
allowing the printed circuit board (40) to cool.

2. A method according to claim 1, wherein the step of applying a solder paste including a solder powder and a polymer flux onto a surface of the printed circuit board in a predefined pattern and to at least partially fill a plurality of thermal vias contained in the printed circuit board further includes the step of applying the solder paste to both surfaces of the printed circuit board.

3. A method according to claim 1, wherein the step of applying a solder paste to the printed circuit board to at least partially fill a plurality of thermal vias contained therein further includes the step of filling each one of a predetermined number of thermal vias with a predetermined amount of the solder paste.

4. A method according to claim 3, wherein the predetermined amount of solder paste is between 25 - 80% of the volume of each thermal via.

5. A method according to claim 3, further including the step of filling all the thermal vias in the printed circuit board with a predetermined amount of the solder paste.

6. A method according to claim 5, wherein the predetermined amount of solder paste is between 50 - 80% of the volume of each thermal via.

7. A method according to claim 2, wherein the step of applying a solder paste including a solder powder and a polymer flux onto a surface of the printed circuit board in a predefined pattern further includes applying the solder paste onto a plurality of pads disposed on the printed circuit board.

8. A method according to claim 7, wherein the step of assembling the components onto the printed circuit board further includes the steps of applying the peripheral contacts of the printed circuit board onto the solder coated pads.

9. A method according to claim 8, further including the step of assembling a plurality of components onto both surfaces of the printed circuit board.

10. A method according to claim 1, wherein during the step of heating the printed circuit board to cause the solder paste to reflow further includes the step of causing the solder paste to flow from the surface of the printed circuit board into the thermal vias by capillary flow.
